Europäisches Patentamt

European Patent Office

Office européen des brevets

(19)

(11) Publication number: **0 130 376**
A2

(12) **EUROPEAN PATENT APPLICATION**

(21) Application number: **84106170.8**

(22) Date of filing: **30.05.84**

(51) Int. Cl.⁴: **H 03 K 19/086**

(30) Priority: **30.06.83 US 509675**

(43) Date of publication of application: **09.01.85**
**Bulletin 85/2**

(84) Designated Contracting States: **DE FR GB**

(71) Applicant: **International Business Machines Corporation, Old Orchard Road, Armonk, N.Y. 10504 (US)**

(72) Inventor: **Banker, Dennis Clark, 1 Lancer Drive, Newburgh New York 12550 (US)**
Inventor: **Barish, Arnold Eugene, Meddaugh Road, Pleasant Valley New York 12569 (US)**
Inventor: **Ehrlickman, Edward Lewis, 7 Hillside Terrace, Suffern New York 10901 (US)**

(74) Representative: **Rudack, Günter Otto, Dipl.-Ing., IBM Switzerland Zurich Patent Operations Säumerstrasse 4, CH-8803 Rüschlikon (CH)**

(54) **Low-voltage dual-phase logic circuit.**

㊸ In this low-voltage dual-phase logic circuit having an improved noise immunity and delay time, an inverter stage (T2) receives the same input signal as an input current switch stage (T1). The output of the inverter (T2) is fed back via a reference transistor (T3) to the reference node (52) of the current switch circuit (T1) to drive the potential at that node (52) in phase opposition to the logic input signal. The outputs of the current switch stage (T1) and the inverter (T2) are used to drive emitter-follower output buffer transistors (T4, T5).

## LOW-VOLTAGE DUAL-PHASE LOGIC CIRCUIT

The invention relates to a low-voltage dual-phase logic circuit, and in particular to a logic circuit of the current switch emitter-follower type.

Low-voltage (approximately 2 volts) single-phase current switch emitter-follower type logic circuits are known in the art. Examples for relevant publications are the following:

- L. Weiss and T.S. Jen, "Achieving Subnanosecond Delays Using Feedback with the Current-Switch", IEEE J. Solid State Circuits, Vol. SC-1, pp. 86-94, December 1966;

- H.M. Rein and R. Ranfft, "Improved Feedback ECL Gate with Low Delay-Power Product for the Subnanosecond Region", IEEE J. Solid State Circuits, Vol. SC-12, pp. 80-82, February 1977;

- J.B. Hughes, "Comments on 'Improved Feedback ECL Gate with Low Delay-Power Product for the Subnanosecond Region'", IEEE J. Solid State Circuits, Vol. SC-13, pp. 276-278, April 1978;

- IBM Technical Disclosure Bulletin, Vol. 23, No. 7A, December 1980, "Half-Current Switch Circuit" by A. Bass et al., pp. 2813-2814;

- US-A-3,509,363;

- US-A-4,283,640.

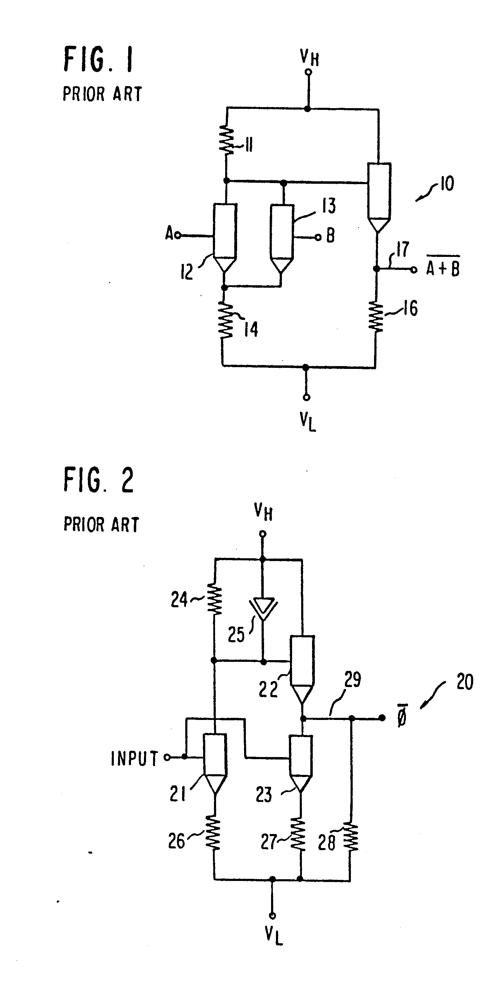

Figures 1 and 2 of the drawings show examples of prior art logic circuits, respectively taken from the IBM Technical Disclosure Bulletin and US-A-3,509,640, Fig. 1 showing a half-current switch circuit and Fig. 2 a low-voltage inverter circuit. In the half-current switch circuit of Fig. 1, the conductive channels (collector-to-emitter paths) of transistors 12 and 13 are coupled in parallel, with the collectors thereof being connected through a resistor 11 to a positive power supply potential $V_H$ and the emitters through a resistor 14 to a negative power supply potential $V_L$. The collectors of the transistors 12 and 13 are also applied to the base of an emitter-follower output transistor 15, the collector of which is connected directly to $V_H$ and the emitter of which is passed through a resistor 16 to $V_L$.

Operationally, the logic NOR of input signals A and B, which are applied to the bases of the transistors 12 and 13, respectively, is produced at the emitter output terminal 17 of the transistor 15. Specifically, when either of the transistors 12 or 13 is turned on by one of the input logic signals A or B being in its positive or UP state, the base of the transistor 15 is pulled negatively, thereby lowering the current in the transistor 15, and hence causing the output terminal 17 to be pulled negatively through the resistor 16. On the other hand, when both of the input signals A and B are in their negative or DOWN state, the transistors 12 and 13 are turned off, thereby permitting base current to flow into the base of the transistor 15 through the resistor 11. This turns on the transistor 15 strongly, pulling the output terminal 17 positively.

In the low-voltage inverter circuit of Fig. 1, an input signal is applied to the base of a transistor 21, of which the collector is connected through a resistor 24 to the positive power supply potential $V_H$ and the emitter through a resistor 26 to the negative power supply potential $V_L$. A Schottky-barrier diode 25 is connected in parallel with the resistor 24. The collector of the transistor 21 feeds the base of a transistor 22, which is connected in an emitter-follower configuration. The collector of the transistor 22 is connected directly to the positive power supply potential $V_H$, and its emitter to the collector a third transistor 23, the base of which also receives the input signal. A resistor 27 connects the emitter of the transistor 23 to $V_L$. A resistor 28 is connected between the junction point between the transistors 22 and 23 and $V_L$.

When the input signal is in its DOWN state, the transistors 21 and 23 are off and the transistor 22 on. Therefore, the output signal $\bar{\phi}$ on the output terminal 29 is taken positively by the transistor 22. On the other hand, when the input signal is in the UP state, the transistors 21 and 23 are on and the transistor 22 is in a low current state. Thus, the output signal $\bar{\phi}$ on the terminal 29 is in the DOWN state. An inversion of the input signal is thereby produced.

Although the prior art circuits of Fig. 1 are in fact capable of operating from a low power supply voltage, for instance, with a difference of 2 volts between $V_H$ and $V_L$, and do have a quite excellent power-performance advantage, nevertheless, the noise margins for these circuits are not as high as is desired for many applications. Also, the prior art circuits of Figs. 1 and 2 do not provide an in-phase output, that is, the outputs from both are inverted signals. Further, it is desirable in many situations to provide a logic circuit in which the delay times through the circuit is less than what can be attained with the circuits of Figs. 1 and 2.

Jen et al. in United States Patent No. 3,509,363 describe a current switch type transistor logic circuit in which a delayed and in-phase replica of an input logic signal is employed as a reference to a current source supplying current to the input stage of the circuit. This has the advantage of providing a reference signal which is close to the value of the input signal just before a change in state of the input signal occurs. Although some speed advantage may thereby be obtained, nevertheless, because the reference signal must be delayed with respect to the input signal, optimum delay times through the circuit cannot be obtained.

Accordingly, it is an object of the present invention to provide a current switch logic circuit having simultaneously a high-noise margin and fast switching speed while being able to operate from low power supply voltages.

Yet further, it is an object of the invention to provide such a current switch logic circuit which has both inverted and non-inverted outputs.

These, as well as other objects of the invention, are met by a current switch logic circuit including current switch means for producing a signal representing a predetermined logic function, such as a logical OR, NOR or inversion, of at least one input logic signal in response to that logic signal and a reference potential applied to the current switch means, the reference potential being employed for distinguishing UP and DOWN levels of the at least one input logic signal, and means for varying the reference potential in phase opposition to the at least one, input logic signal.

By "phase opposition" is meant ⟊————·————⟊ that, when the input signal is moving in the positive direction, the reference potential is moving in the negative direction, and vice versa. The means for varying the reference potential may be an inverter which receives the same at least one input logic signal as the current switch means. The current switch means may be composed of a transistor having a control electrode coupled to receive the at least one input logic signal, a first current channel electrode coupled to receive the reference potential, and a second current channel electrode on which is produced the signal representing the desired predetermined logic function of the input logic signal or signals.

By "control electrode" is meant the base electrode in the case of a bipolar transistor and the gate in the case of a field-effect transistor, and what is meant by "first current channel electrode" and "second current channel electrode" are the emitter and collector electrodes in the case of a bipolar transistor and the source and drain electrodes in the case of a field-effect transistor. An output stage may be provided for producing an output logic signal, having the desired UP and DOWN logic signal levels, in accordance with the signal representing the predetermined logic function of the input logic signal produced by the current switch means. The output stage may provide true and complementary (uninverted and inverted, respectively) output signals.

Further, the invention can be practiced by a dual-phase current switch logic circuit in which

0130376
FI 9-82-058

in-phase and inverted outputs of an input phase-splitting transistor circuit are coupled to respective emitter-follower transistor circuits, with the in-phase output coupled to its corresponding emitter-follower transistor circuit via a reference transistor. A transistor inverter feedback circuit is coupled between the input to the input-phase splitting transistor circuit and a reference node of the reference transistor so as to vary the reference potential at the reference node in phase opposition to the phase of the input signal. A logic circuit having a high noise margin and one which is capable of operating from low circuit voltages is thereby obtained.

Details of two examples of embodiments of the invention are hereafter described with reference to the appended drawings in which:

Fig. 1 is a schematic diagram of a prior art half-current switch circuit;

Fig. 2 is a schematic diagram of a prior art low-voltage inverter circuit;

Fig. 3 is a schematic diagram of a first embodiment of a logic circuit of the invention;

Fig. 4 is a schematic diagram of a second embodiment of a logic circuit of the invention; and

Fig. 5 is a waveform diagram used to explain the operation of the circuit of Fig. 3.

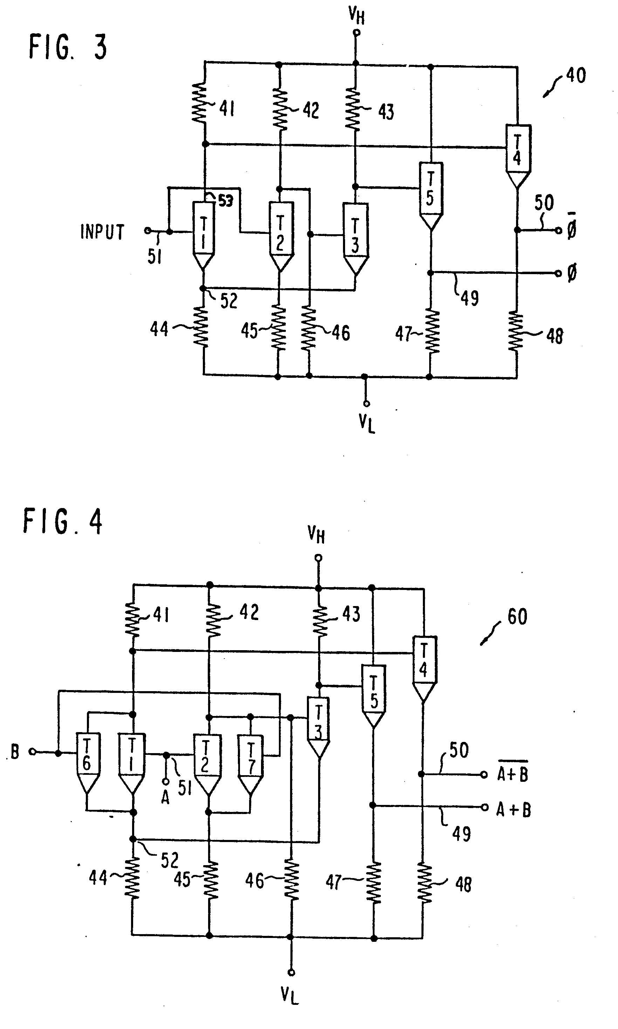

Referring now to Fig. 3, a low-voltage dual-phase logic circuit, indicated generally by reference numeral 40, constructed in accordance with the teachings of the invention will now be described. An input signal on an input terminal 51 is applied to bases of transistors T1 and T2. The collectors of the transistors T1 and T2 are coupled to the positive power supply potential $V_H$ through resistors 41 and 42, respectively, while their emitters are coupled to the negative power supply potential $V_L$ through respective resistors 44 and 45. It should be noted that the resistance values of the resistors 42, 45 and 46 are chosen so that the voltage swings on the collector of the transistor T2 will be less than those on the collector of the transistor T1. The collector output 53 of the input transistor T1 is connected to the base of an emitter-follower output transistor T4, the collector of which is connected directly to $V_H$ and the emitter of which is connected through a resistor 48 to $V_L$. The collector output of the transistor T2 is applied to the base of a transistor T3, the collector of which drives the base of a second output emitter-follower transistor T5 and is coupled to the positive power supply potential $V_H$ through a resistor 43. The emitter of the transistor T3 is connected directly to the emitter of the input transistor T1 forming a current switch, that is, to the reference potential node 52 thereof. The collector of the output transistor T5 is connected directly to $V_H$, and its emitter through a resistor 47 to $V_L$. An uninverted output signal $\phi$ on a terminal 49 is produced at the emitter of the transistor T5 and an inverted output $\bar{\phi}$ on a terminal 50 at the emitter of the transistor T4.

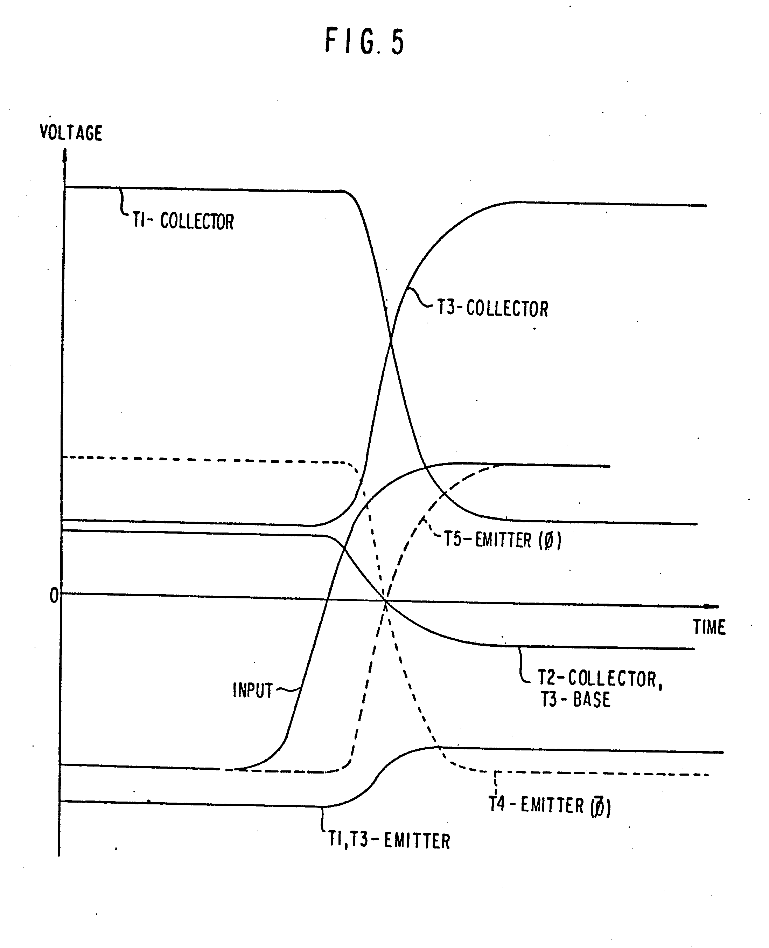

The operation of the circuit of Fig. 3, which is an inverter/buffer circuit, will be explained with reference to the waveform diagrams of Fig. 5. When the input signal on the terminal 51 is in the DOWN state, both of the transistors T1 and T2 are turned off. Base current can then flow to the transistor T4, thereby taking the output terminal 50 to the UP logic level. The transistor T2 is turned off, thereby supplying base current to the transistor T3 through the biasing produced by the resistors 42 and 46. This action lowers the emitter current flowing through the transistor T5, and thus holding the uninverted output signal $\phi$ on the output terminal 49 in the DOWN logic state. The above-described state is illustrated in the left-hand portion of Fig. 5, that is, the portion of Fig. 5 before the input signal starts to rise.

When the input signal on the input terminal 51 starts to rise, the collectors of the transistors T1 and T2 will move in the negative direction. Hence, the base drive to the transistor T3 is reduced, thereby reducing the amount of current supplied through the transistor T3 to the node 52 at the junction of the emitter of the transistors T1 and the resistor 44. This has the effect of driving the node 52 in phase opposition to the input signal, and causing T1 to conduct sooner. The result is to widen the noise margin of the circuit and to increase the signal switching speed at lower power supply voltages than previously possible.

When the input signal on the terminal 51 reaches the UP level, the current in the transistor T4 will be decreased and that in the transistor T5 increased. Thus, inverted and non-inverted versions of the input signal on input terminal 51 are provided on output terminals 50 and 49, respectively. It can be appreciated from the waveform diagram of Fig. 5 that the output signals $\phi$ and $\overline{\phi}$ are symmetrical with respect to ground, and they cross the ground level at substantially the same time, as is desired for a logic circuit.

Fig. 4 shows a modification of the circuit of Fig. 3 in the form of an OR/NOR gate circuit. In the circuit of Fig. 4, transistors T6 and T7 have been

0130376

added, to the bases of which a second input signal B is applied. An input signal A is applied to the bases of transistors T1 and T2. The transistors T6 and T7 are connected in parallel with the transistors T1 and T2, respectively. Otherwise, the circuit construction is the same as that of Fig. 3. By following through the circuit operation in the manner described above, it can easily be appreciated by one of ordinary skill in the art that, in this case, the output signals on terminals 49 and 50 represent $A + B$ and $\overline{A + B}$, respectively.

## C L A I M S

1. Low-voltage dual-phase logic circuit, characterized by a current switch (T1, T5) for producing a signal representing a predetermined logic function in response to at least one logic input signal and a reference potential, and

means (T3) for varying said reference potential in phase opposition to said logic input signal,

said means comprising an inverter (T1) receiving said logic input signal for inverting the phase thereof.

2. Logic circuit in accordance with claim 1, characterized in that said current switch (T1, T5) comprises a transistor (T1) having a control electrode (51) coupled to receive said logic input signal, a first current channel electrode (52) coupled to receive said reference potential, and a second current channel electrode (53) on which is produced said signal representing said predetermined logic function of said logic input signal.

3. Logic circuit in accordance with claim 2, characterized in that said current switch (T1, T5) comprises a bipolar transistor (T1), said control electrode (51) being the base of said transistor (T1), said first current channel electrode (52) being the emitter of said transistor (T1), and said second current channel electrode (53) being the collector of said transistor (T1).

4. Logic circuit in accordance with any one of claims 1 through 3, characterized by an output stage (T4, T5) for producing at least one output signal having predetermined logic signal levels in response to said input signal.

5. Logic circuit in accordance with claim 4, characterized in that said output stage (T4, T5) comprises means (T3) for producing first and second output signals $(\phi, \overline{\phi})$ having said predetermined logic signal levels, said first and second output signals having states complementary to one another.

6. Logic circuit in accordance with claim 1, characterized in that in-phase and inverted outputs $(\phi, \overline{\phi})$ of an input phase-splitting transistor circuit (T1) are coupled to respective emitter-follower transistor circuits (T5 and T4) with the in-phase output coupled to its emitter-follower transistor circuit via a reference transistor (T3), and that an inverter feedback circuit (T2) is coupled betweeen the input to said input phase-splitting transistor (T1) and a reference node (52) of said reference transistor (T3) so as to vary the reference potential at said reference node (52) in phase opposition to the phase of said input signal.

7. Logic circuit in accordance with claim 6, characterized in that said inverter feedback circuit comprises a first transistor (T2) receiving on its base said input signal and having a collector and an emitter coupled resistively to positive and negative power supply potentials $(V_H, V_L)$, respectively; and a second trannsistor (T3) having a base coupled to said collector of said first transistor (T2), a collector coupled resistively to said positive power supply potential $(V_H)$, and an emitter coupled to said reference node (52).

8. Logic circuit in accordance with claim 1, characterized by a first transistor (T1) having a base receiving an input signal, a collector coupled through a first resistor (41) to a positive power supply potential $(V_H)$, and an emitter coupled through a second resistor (44) to a negative power supply potential $(V_L)$, a second transistor (T2) having a base receiving said logic input signal, a collector coupled through a third resistor (42) to said positive power supply potential $(V_H)$, and an emitter coupled through a fourth resistor (45) to said negative power supply potential $(V_L)$; a third transistor (T3) having a base coupled to said collector of said second transistor (T2), a collector coupled through a fifth resistor (43) to said positive power potential $(V_H)$, and an emitter coupled to said emitter of said first transistor (T1); a fourth transistor (T4) having a base coupled to said collector of said first transistor (T1), a collector coupled to said positive power supply potential $(V_H)$, and an emitter coupled through a sixth resistor (48) to said negative power supply potential $(V_L)$; and a fifth transistor (T5) having a base coupled to said collector of said third transistor (T3), a collector coupled to said positive power supply potential $(V_H)$, and an emitter coupled through a seventh resistor (47) to said negative power supply potential $(V_L)$, the output terminals (49, 50) being associated with said in-phase and inverted output signals $(\emptyset, \overline{\emptyset})$ being connected to the emitters of said fifth and fourth transistors (T5, T4).

9.   Logic circuit in accordance with claim 8, characterized by a sixth transistor (T6) having a base coupled to receive a second logic input signal (B), a collector coupled to said collector of said first transistor (T1), and an emitter coupled to said emitter of said first transistor (T1); and a seventh transistor (T7) having a base coupled to receive said second logic input signal (B), a collector coupled to said collector of said second transistor (T2), and an emitter coupled to said emitter of said second transistor (T2), a logical OR function of said first and second logic input signals (A, B) being produced at said emitter (49) of said fifth transistor (T5), and a logical NOR function of said first and said second input signals being produced at said emitter (50) of said fourth transistor (T4).

0130376

1/3

# FIG. 1
PRIOR ART

$V_H$

11

13

10

A

B

12

17

$\overline{A+B}$

14

16

$V_L$

# FIG. 2
PRIOR ART

$V_H$

24

25

22

29

20

INPUT

$\overline{\emptyset}$

21

23

26

27

28

$V_L$

FIG. 3

INPUT

FIG. 4

# FIG. 5

VOLTAGE

TI- COLLECTOR

T3-COLLECTOR

T5-EMITTER (Ø)

0

TIME

T2-COLLECTOR,
T3- BASE

INPUT

T4 - EMITTER (Ø̄)

TI,T3- EMITTER